# FASCICULE DE BREVET EUROPEEN

(11) **EP 0 974 193 B1**
(45) Date de publication et mention de la délivrance du brevet: **16.01.2002**
(21) Numéro de dépôt: 98917286.1
(22) Date de dépôt: 01.04.1998
(51) Int. Cl.: H03K 5/01, H03K 5/159

(54) **GENERATEUR ELECTRIQUE DE PROFILS TEMPORELS ARBITRAIRES, PROGRAMMABLE OPTIQUEMENT**
OPTISCH PROGRAMMIERBARER ELEKTRISCHER GENERATOR FÜR PROFILE BELIEBIGER ZEITRELATION
OPTICALLY PROGRAMMABLE ARBITRARY TEMPORAL PROFILE ELECTRIC GENERATOR

(30) Priorité: 04.04.1997 FR 9704140
(43) Date de publication de la demande: 26.01.2000
(73) Titulaire: COMMISSARIAT A L'ENERGIE ATOMIQUE, 75015 Paris Cédex 15 (FR)
(72) Inventeur: JOLLY, Alain, F-28130 Houx (FR)
(74) Mandataire: Dubois-Chabert, Guy
(86) Numéro de dépôt international: FR9800660
(87) Numéro de publication internationale: WO9845945

(56) Documents cités:
- WO-A-97/23980
- US-A- 4 176 285
- US-A- 4 482 816
- US-A- 4 670 662

## Description

### Domaine technique

La présente invention concerne un générateur électrique de profils temporels arbitraires, programmable optiquement.

### Etat de la technique antérieure

Les documents référencés [1], [2] et [3] (voir aussi le document WO-A-97/23980), en fin de description décrivent un dispositif de conformation d'impulsions contrôlé par un ordinateur utilisant des transistors à effet de champ AsGa, mais ces dispositifs sont limités en fréquences et en tension.

Le document référencé [4] décrit un dispositif de mise en forme haute fréquence, mais non programmable par ordinateur.

Le document référencé [5] décrit un générateur d'impulsions électriques, dans lequel deux lignes de transmission sont couplées l'une avec l'autre par des éléments résistifs distribués le long de ces lignes, la valeur de la conductance de chaque couplage résistif étant fonction de sa position le long de la ligne, pour produire la forme d'impulsion désirée sur l'une des lignes par application d'une impulsion sur l'autre ligne.

L'invention a pour objet un générateur électrique de profils temporels capable de fournir des profils de tension arbitraires, en haute ou basse tension, et à pas de programmation Δt très court.

### Exposé de l'invention

La présente invention concerne un générateur électrique de profils temporels arbitraires programmable optiquement, comprenant une première ligne hyperfréquence de déclenchement et une seconde ligne hyperfréquence de décharge couplées résistivement, par points, la première ligne étant déclenchée par une transition de tension de durée inférieure à une nanoseconde, par exemple tune impulsion ou un échelon, caractérisé en ce que plusieurs points sont prélevés sur la première ligne par plusieurs photoconducteurs en mode résistance variable, couplés directement sur la seconde ligne, éclairés par une source de lumière programmable, la pas temporel entre les points de prélèvement étant différent sur ces deux lignes, une charge résistive étant connectée en sortie de ce générateur.

Avantageusement une capacité peut éventuellement être disposée entre chaque photoconducteur et la seconde ligne permettant d'isoler en continu la première ligne de la seconde. Les photoconducteurs sont réalisés en matériaux semi-conducteurs pris parmi les matériaux suivants : silicium, arséniure de gallium. Chaque source de lumière programmable peut être une lampe à gaz ultraviolet - visible - infrarouge, ou une diode semi-conductrice électroluminescente ou laser.

Avantageusement chaque source de lumière peut être alimentée par une source de courant indépendante commandée en tension, le signal d'entrée de cette source de courant étant délivré par un générateur de tension multivoie programmable piloté par un calculateur.

Avantageusement chaque source de lumière programmable produit un éclairement variable, programmé en référence à une consigne, qui définit la valeur de la résistance du photoconducteur, auquel elle est couplée, à l'instant de déclenchement du générateur.

Avantageusement les deux lignes sont des lignes à ruban droites réalisées à partir de dépôts métalliques sur deux substrats respectivement associées à deux diélectriques de constantes diélectriques différentes. Les deux lignes hyperfréquences ont chacune une résistance caractéristique comprise entre 10 Ω et 100 Ω, le substrat ayant une tangente de perte tg δ ≈ 10⁻³ à 10 Ghz. Le déclenchement de la première ligne peut être un déclenchement électrique, ou photoélectrique, de type indiciel ou impulsionnel. Un filtre peut être disposé entre la sortie et la charge, ce qui permet de lisser le profil temporel obtenu.

Avantageusement le pas de programmation est compris entre trente picosecondes et une nanoseconde. Il est défini par l'espacement entre deux photorésistances.

Un tel générateur électrique de profils temporels préprogrammé par photoconducteurs, qui est déclenché par un autre générateur, permet la mise en forme temporelle (MEFT) d'impulsions courtes. Selon la taille de la fenêtre temporelle dans laquelle le profil doit être programmé, et le générateur de déclenchement disponible, le pas Δt peut varier entre quelques dizaines et quelques centaines de picosecondes.

Dans une utilisation avantageuse, ce générateur peut être couplé à un cristal électro-optique utilisant l'effet Pockels pour réaliser un modulateur d'amplitude d'impulsions laser.

Par rapport aux dispositifs de l'art antérieur, le générateur de l'invention présente de nombreuses caractéristiques originales, et notamment les suivantes :

Le couplage par photoconducteurs en mode résistance préprogrammée optiquement, et donc la fonction de générateur de mise en forme temporelle est programmable de façon électronique.

Le principe de la mise en forme temporelle repose sur un schéma électrique de programmation par composants préprogrammés en mode « quasi statique », par opposition, par exemple, aux dispositifs décrits dans les documents référencés [1], [2] et [3] en fin de description, utilisant des composants commutés en régime dynamique.

La technologie des photoconducteurs fonctionnant en résistance variable sous l'effet d'un éclairement par diodes laser (ou autres sources) permet une action sur les lignes hyperfréquence sans contact physique entre la commande et la structure programmée, ce qui permet d'en optimiser le comportement en hautes fréquences et en simplifie beaucoup la réalisation.

Il n'y a pas de composants actifs rapides, hors déclenchement, du type commutateur à transistor à effet de champ GaAs, comme dans les documents référencés [1] à [3] par exemple. Dans un tel cas, le comportement en hautes fréquences est limité par la rapidité des transistors à effet de champ.

Dans le générateur de l'invention la limitation en hautes fréquences provient uniquement du générateur de déclenchement et des pertes dans les lignes.

Il est possible d'obtenir une dynamique très importante dans la programmation des photoconducteurs Rj en mode résistance, les photoconducteurs étant éclairés en mode quasi continu. La limite sur la dynamique provient du rapport « signal/bruit » sur la valeur préprogrammée Rj, donc du courant d'obscurité du photoconducteur et du bruit de la source d'éclairement. Ce rapport, qui peut dépasser 30 dB, est fonction des conditions de mise en oeuvre du photoconducteur.

Il n'y a aucun jitter des pas de temps par rapport! à la transition de déclenchement, par comparaison avec des dispositifs n'utilisant pas de source d'e déclenchement unique.

L'invention est simple et versatile d'un point de vue électronique et optoélectronique. Elle est d'un faible coût, si les sources de programmation optique par diodes laser (actuellement encore onéreuses) sont remplacées par des lampes à gaz. Elle est de faible volume en intégrabilité, par rapport à des solutions utilisant des composants électriques discrets, pour hyperfréquences, du type atténuateur variable.

L'usage de photoconducteurs en régime quasi statique, pour rendre programmable le générateur de mise en forme temporelle, permet d'associer tous les avantages pour un meilleur compromis « haute tension - grande dynamique - hautes fréquences ». Avec un déclenchement utilisant un photoconducteur, la mise en forme d'impulsions électriques ou optique (via un modulateur électro-optique) peut être effectuée avec les caractéristiques suivantes :
- pas de temps compris entre 30 et 100 picosecondes ;
- niveaux de tension dépassant 5 KVolts ;
- dynamique de programmation comprise entre 10 et 30 dB min.

L'une des applications immédiates du générateur de l'invention est celle de permettre la mise en forme temporelle d'une impulsion optique fournie par un laser, par découpage à l'aide d'un modulateur électro-optique selon un profil prédéfini à l'instant de l'arrivée de l'impulsion de déclenchement.

Un grand nombre d'autres applications peuvent être envisagées, dès lors qu'il est nécessaire de fournir à une charge résistive un profil de tension entrant dans un gabarit de temps défini précédemment, et dans une gamme de niveaux pouvant s'étendre de quelques Volts à plusieurs Kilovolts.

### Brève description des dessins

- La figure 1 illustre une réalisation du générateur électrique selon l'invention ;
- la figure 2 illustre un exemple de schéma pour le calcul du générateur électrique selon l'invention ;
- les figures 3 et 4 illustrent deux formes de signaux obtenus en sortie du générateur électrique selon l'invention ; la figure 3 représentant le déclenchement par un échelon et la figure 4 le déclenchement par une impulsion courte.

### Exposé détaillé de modes de réalisation

Le générateur programmable de l'invention est basé sur un ensemble de deux lignes hyperfréquences 10, 12 couplées résistivement, incorporant des photoconducteurs 11 programmables de façon électronique par des diodes laser 13 (ou autres sources optiques solides et à gaz) et déclenché par un interrupteur rapide placé en P qui fournit une transition de tension très brève, typiquement de quelques dizaines à quelques centaines de picosecondes. Cet interrupteur permet de déclencher le générateur, par voie électrique ou électro-optique (interrupteur de type photoconducteur).

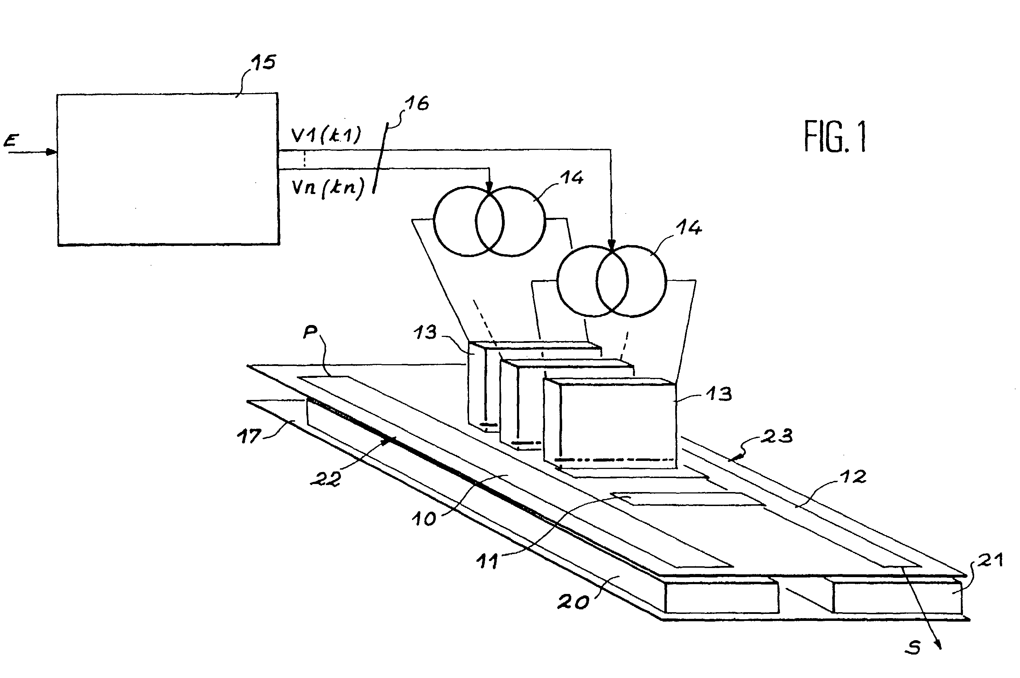

Comme illustré sur la figure 1, ce générateur comprend un première ligne 10 (ligne de déclenchement) déclenchée à l'aide d'une impulsion (Dirac) ou d'une transition brève (échelon) de tension (P étant le point de déclenchement), qui permet de propager ce signal à vitesse constante.

Plusieurs points, équirépartis ou non, sont définis sur cette première ligne 10, et couplés à autant de photoconducteurs en mode résistance 11, directement ou à travers une capacité, sur une seconde ligne 12. La fonction de ces capacités est d'isoler en continu la première ligne de la seconde, ce qui permet de limiter la consommation du générateur. Le choix d'utiliser ou non une capacité de liaison est aussi lié à d'éventuelles contraintes sur le dimensionnement des photoconducteurs 11 en fonction de leur état de polarisation. La seconde ligne 12 (ligne de décharge) est couplée à la première uniquement par l'intermédiaire de ces photoconducteurs. Les couplages parasites répartis sont limités autant que possible en contrôlant la géométrie, les dimensions et la distribution des masses de l'ensemble. Les photoconducteurs de couplage 11 sont programmables, ce qui permet d'obtenir un générateur de profils électriques en tension programmable. Les photoconducteurs en mode résistance variable sont réalisés à base de matériaux semi-conducteurs de type silicium (Si), arséniure de gallium (GaAs) ou autres, éclairés par un ensemble de sources de lumière programmables qui peut être :
- un ensemble de lampes à gaz « ultraviolet
- visible - infrarouge » ;
- un ensemble de diodes semi-conductrices électroluminescentes (LED) ou laser (DL).

Sur la figure 1 sont représentées des diodes laser 13 qui sont alimentées par des sources de courant indépendantes 14 commandées en tension. Les signaux d'entrée V1(t1), Vn(tn) de ces sources de courant sont délivrés par un générateur de commande multivoie programmable 15 via un bus de commande 16, ce générateur étant piloté par un signal E issu d'un calculateur.

Chacune des sources de lumière 13 produit un éclairement variable, programmé en référence à une consigne, qui définit la valeur de la résistance du photoconducteur auquel elle est couplée à l'instant du déclenchement du générateur.

Les lignes 10 et 12 sont des lignes de type « ruban » réalisées à partir de dépôts métalliques sur substrats diélectriques 22, 23. Ces substrats 22, 23 sont à faibles pertes, pour pouvoir passer 3 à 10 Ghz, et possèdent une tangente de perte tgδ ≈ 10⁻³ à ces fréquences. Les paramètres de base de chacune des deux lignes 10 et 12 sont l'impédance caractéristique et la distance séparant deux photoconducteurs 11 voisins, et donc le pas temporel.

Dans le cas d'une configuration haute tension, la nature et l'épaisseur du diélectrique sont choisies pour respecter les critères de tenue en tension.

Les deux lignes 10 et 12 ne fonctionnent pas avec le même pas temporel et la différence des deux pas est exploitée pour définir la mise en forme.

En fonctionnement, la première ligne 10 propage la transition de déclenchement, ce qui définit un pas de temps élémentaire entre photoconducteurs, et induit une transition de courant ΔI = ΔV /R, R étant la valeur de résistance, cette transition étant propagée et contre-propagée dans la seconde ligne 12.

Comme illustré sur la figure 1 on utilise deux lignes droites à ruban 10 et 12, associées à deux diélectriques 20 et 21 de permittivités (ε) différentes. Un rapport 4 sur les valeurs de ε permet d'obtenir un rapport 2 sur les vitesses de propagation, soit un rapport 2 sur les pas de temps si on implante les photoconducteurs comme illustré sur la figure. Cette solution est simple d'un point de vue technologique. Il suffit de contrôler les résistances caractéristiques par l'intermédiaire des largeurs des deux rubans linéaires. Ces résistances caractéristiques peuvent varier typiquement, pour les diélectriques classiques, de quelques ohms à 200 ohms.

Dans le générateur de l'invention, chaque ligne a une résistance caractéristique comprise entre 10 Ω et 100 Ω, ces deux lignes pouvant avoir des résistances caractéristiques identiques ou différentes. Le choix de ces résistances caractéristiques influe sur les critères d'optimisation du générateur : rendement électrique, tenue en haute tension, caractéristiques de la source de déclenchement.

Dans cette réalisation le pas de temps est compris entre trente picosecondes et une nanoseconde.

Les photoconducteurs (Rj) sont très faiblement capacitifs, ce qui permet au générateur de fonctionner en hautes fréquences. Pour un pas de temps égal à 100 ps sur la ligne de déclenchement et une gamme de valeurs Rj = 1 à 200 ohms par exemple, la capacité associée à Rj ne doit pas excéder Cj = 0.2 pF. On utilise donc une géométrie de photoconducteur sous forme de barrette longue, éclairée uniformément sur sa longueur (Dj) et dans son volume. Pour Dj = 1 cm, une largeur de 1 à 3 mm et un matériau photoconducteur type Si ou GaAs, Cj n'excède pas quelques dizaines de fF.

En régime établi il n'y a pas de hautes fréquences, en ce qui concerne les contraintes dues aux photorésistances.

Si on considère le cas d'un déclenchement haute tension par photoconducteur, couplé à une ligne de stockage de l'énergie, une transition de 5 KV avec un temps de montée inférieur à 100 ps peut ainsi être appliquée à l'entrée de la ligne de déclenchement 10.

Le générateur de l'invention est préprogrammé à l'instant du déclenchement, c'est-à-dire lorsque la transition de déclenchement est envoyée sur la première ligne 10, en P.

On peut avoir un déclenchement électrique ou photoélectrique de la première ligne 10 : dans ce dernier cas on utilise un photoconducteur éclairé par un laser. On peut utiliser différents types de déclenchement indiciel ou impulsionnel.

La sortie (S) du générateur de l'invention est connectée à une charge résistive : ce peut être un générateur électrique de fonction sur charge résistive ou un modulateur électro-optique.

On peut placer un élément de filtrage entre la sortie et la charge, ce qui permet de lisser le profil temporel obtenu. Un lissage peut aussi être obtenu en augmentant la valeur du temps de montée de la transition en P.

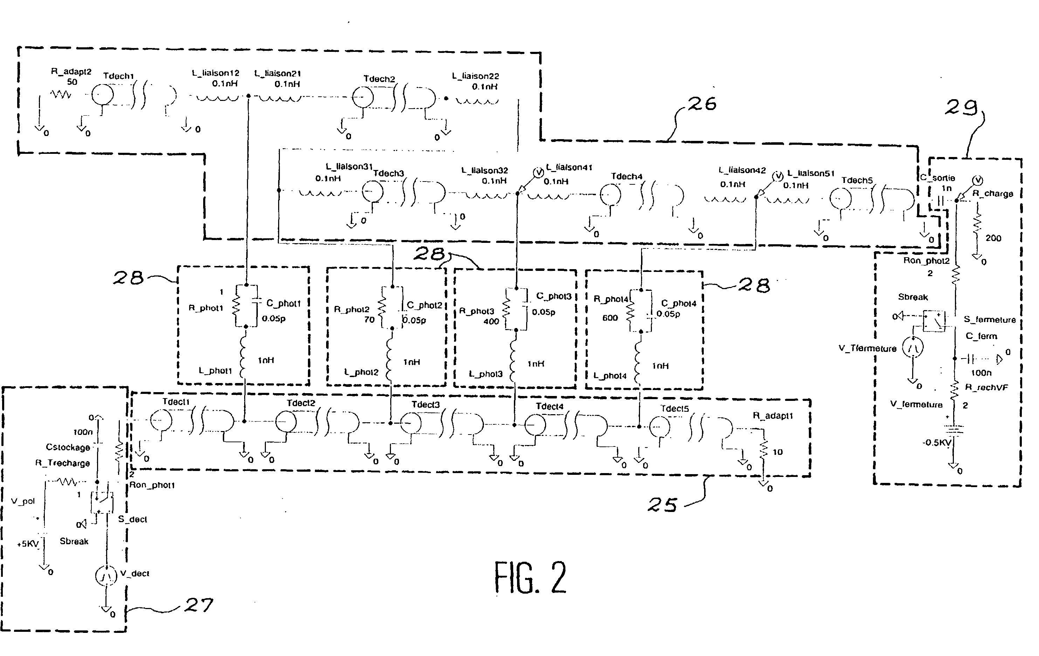

La figure 2 illustre un exemple de schéma pour le calcul du générateur selon l'invention. On a un fonctionnement sur quatre points à base de photoconducteurs pré-ajustés en quasi-statique, avec une ligne de déclenchement 25 à impédance 10 ohms constante, une ligne de décharge 26 à impédance 50 ohms constante, un circuit 27 de déclenchement par photoconducteur série GaAs, des réseaux RC 28 représentant le schéma équivalent au photoconducteur quasi-continu (QCW) et un modulateur électro-optique 29 (avec, dans ce cas précis, compensation des effets mécaniques dans le modulateur).

Les éléments de ligne « Tdect » et « Tdech » représentent les tronçons de ligne à ruban entre lesquels sont implantés les points de couplage résistif.

Ces couplages sont effectués sans liaison capacitive. Les éléments « R_phot », « C_phot » et « L_phot » représentent respectivement une photorésistance programmée, une capacité et une self inductance parasite associée, ces éléments parasites étant minimisés au maximum. Les interrupteurs « S_dect » et « S_fermeture », commandés par les générateurs de tension « V_dect » et « V_Tfermeture », sont une représentation simplifiée du générateur d'injection, et de l'interrupteur de fermeture qui détermine la fenêtre temporelle de mise en forme. « S_dect » peut en particulier être un photoconducteur sur lequel on couple un laser à impulsions courtes (de l'ordre de 10 à 30 picosecondes). La capacité « Cstockage » est nécessaire d'un point de vue électronique pour accumuler l'énergie avant l'instant de déclenchement (déclenchement type « série »).

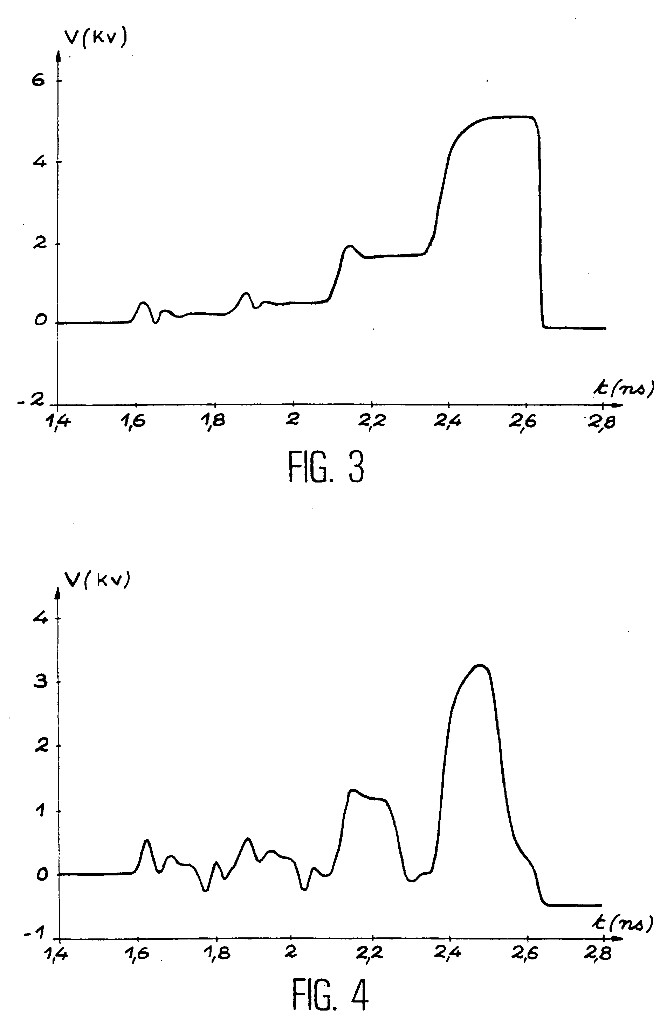

Cet exemple de réalisation suppose le générateur couplé à un modulateur électro-optique à ondes progressives simplement représenté par une résistance de charge « R_charge ». La source de tension « V_fermeture », non nulle, a pour rôle de compenser les effets mécaniques (et autres) induits dans le cristal du modulateur par les transitions haute tension. Ainsi, il est possible de contrôler le contraste à la fermeture du système, après la transition arrière de la fenêtre temporelle « T ». Les simulations sont effectuées dans les deux cas extrêmes où l'on utilise comme signal de déclenchement :
- un échelon, avec un photoconducteur pour lequel la durée de vie des porteurs de charge est grande devant « T » comme illustré sur la figure 3 ;
- une impulsion courte de type Dirac, avec un photoconducteur pour lequel cette même durée de vie est courte ou du même ordre de grandeur que T, comme illustré sur la figure 4.

### REFERENCES

[1] « National Ignition Facility Front End Laser System » de S.C. Burkhart, R.J. Beach, J.H. Crane, J.M. Davin, M.D. Perny, R.B. WILCOX (Solid State Lasers for Application to Inertial Confinement Fusion Conferencè, proceedings page 48, Monterey - CA, 31 mai-2 juin 1995)
[2] « Temporal Pulse Shaping Of Fiber Optic laser Beams » de S.C. Burkhart et F.A. Penko (inertial Confinement Fusion, ICF Quarterly Report, janvier-mars 1996, volume 6, numéro 2)
[3] « Pilote-Source-Mise en forme temporelle » de Y. Hourmand (note technique DRIF/DCRE n° 443/96 du 2 juillet 1996)
[4] « Mise en forme des impulsions du laser PHEBUS » de D. Salaun (note CEA/CELV/DLPP de juillet 1989)
[5] US-A-4 176 285

## Revendications

1. Générateur électrique de profils temporels arbitraires programmable optiquement, comprenant une première ligne hyperfréquence (10) de déclenchement et une seconde ligne hyperfréquence (12) de décharge couplées résistivement, par points, la première ligne étant déclenchée par une transition de tension de durée inférieure à une nanoseconde ; **caractérisé en ce que** plusieurs points sont prélevés sur la première ligne par plusieurs photoconducteurs (11) en mode résistance variable, couplés directement sur la seconde ligne, éclairés par une source de lumière programmable (13), la pas temporel entre les points de prélèvement étant différent sur ces deux lignes, une charge résistive étant connectée avec ladite seconde ligne hyperfréquence (12) en sortie de ce générateur.

2. Générateur selon la revendication 1, dans lequel une capacité est disposée entre chaque photoconducteur (11) et la seconde ligne (12) permettant d'isoler en continu la première ligne (10) de la seconde (12).

3. Générateur selon la revendication 1, dans lequel les photoconducteurs (11) sont réalisés en matériaux semi-conducteurs pris parmi les matériaux suivants : silicium, arséniure de gallium.

4. Générateur selon la revendication 1, dans lequel chaque source de lumière programmable (13) est une lampe à gaz.

5. Générateur selon la revendication 1, dans lequel chaque source de lumière programmable (13) est une diode semi-conductrice électroluminescente ou laser.

6. Générateur selon la revendication 5, dans lequel chaque source de lumière programmable (13) est alimentée par une source de courant indépendante (14) commandée en tension, le signal d'entrée (V1(t1), Vn(tn)) de cette source de courant étant délivré par un générateur de tension multivoie programmable (15) piloté par un calculateur.

7. Générateur selon la revendication 1, dans lequel chaque source de lumière programmable produit un éclairement variable, programmé en référence à une consigne, qui définit la valeur de la résistance du photoconducteur, auquel elle est couplée, à l'instant de déclenchement du générateur.

8. Générateur selon la revendication 1, dans lequel les lignes hyperfréquences (10, 12) sont des lignes de type ruban droites réalisées à partir de dépôts métalliques sur deux substrats (22, 23) de constantes diélectriques (ε) différentes.

## Claims

1. Optically programmable electric generator of arbitrary time profiles, comprising a first ultrahigh frequency triggering line (10) and a second ultrahigh frequency discharge line (12) resistively coupled, by points, the first line being triggered by a voltage transition of duration less than one nanosecond, **characterized in that** several points are sampled from the first line by several photoconductors (11) in variable resistance mode, directly coupled to the second line, illuminated by a programmable light source (13), the time spacing between the sampling points differing on the two lines, a resistive load being connected to said second ultrahigh frequency line (12) at the output (S1, S2) of said generator.

2. Generator according to claim 1, wherein a capacitor is disposed between each photoconductor (11) and the second line (12) making it possible to provide D.C. isolation of the first line (10) from the second (12).

3. Generator according to claim 1, wherein the photoconductors (11) are made of semiconductor materials taken from among the following materials: silicon, gallium arsenide.

4. Generator according to claim 1, wherein each programmable light source (130 is a gas tube.

5. Generator according to claim 1, wherein each programmable light source (130 is a laser or light emitting semiconductor diode.

6. Generator according to claim 5, wherein each programmable light source (13) is supplied by an independent current source (14) controlled voltagewise, the input signal (V1(t1), Vn(tn)) of this current source being delivered by a programmable multi-way voltage generator (15) driven by a computer.

7. Generator according to claim 1, wherein each programmable light source produces a variable illumination, programmed with reference to a set point, which defines the value of the resistance of the photoconductor, to which it is coupled, at the instant the generator is triggered.

8. Generator according to claim 1, wherein the ultrahigh frequency lines (10, 12) are straight strip type lines made from metallic deposits on two substrates (22, 23) of different dielectric constants (ε).

## Patentansprüche

1. Optisch programmierbarer elektrischer Generator für Profile beliebiger Zeitrelation mit einer ersten Hyperfrequenzleitung (10) zur Auslösung und einer zweiten Hyperfrequenzleitung (12) zur Entladung, resistiv gekoppelt, durch Punkte, wobei die erste Leitung ausgelöst wird durch einen Spannungsübergang mit einer Dauer von weniger als einer Nanosekunde,
**dadurch gekennzeichnet,**
**dass** mehrere Punkte in der ersten Leitung durch mehrere direkt mit der zweiten Leitung gekoppelte Photoleiter (11), beleuchtet durch eine programmierbare Lichtquelle (13), im variablen Widerstandsbetrieb abgegriffen werden, wobei die zeitliche Teilung zwischen den Abgreifpunkten in diesen beiden Leitungen unterschiedlich ist und eine resistive Ladung am Ausgang dieses Generators mit der genannten zweiten Hyperfrequenzleitung verbunden ist.

2. Generator nach Anspruch 1, bei dem zwischen jedem Photoleiter (11) und der zweiten Leitung (12) eine Kapazität angeordnet ist, die ermöglicht, die erste Leitung (10) von der zweiten Leitung (12) kontinuierlich zu isolieren.

3. Generator nach Anspruch 1, bei dem die Photoleiter (11) aus Halbleitermaterialien hergestellt sind, die zwischen den folgenden Materialien ausgewählt werden: Silicium, Galliumarsenid.

4. Generator nach Anspruch 1, bei dem jede programmierbare Lichtquelle (13) eine Gaslampe ist.

5. Generator nach Anspruch 1, bei dem jede programmierbare Lichtquelle (13) eine Laser- oder elektrolumineszente Halbleiterdiode ist.

6. Generator nach Anspruch 5, bei dem jede programmierbare Lichtquelle (13) durch eine unabhängige spannungsgesteuerte Stromquelle (14) gespeist wird, wobei das Eingangssignal (V1(t1), Vn(tn)) dieser Stromquelle durch einen rechnergesteuerten programmierbaren Mehrkanal-Spannungsgenerator (15) geliefert wird.

7. Generator nach Anspruch 1, bei dem die programmierbare Lichtquelle eine variable Beleuchtung erzeugt, programmiert in Bezug auf einen Einstellwert bzw. Sollwert, der zum Zeitpunkt der Auslösung des Generators den Wert des Widerstands des Photoleiters definiert, mit dem er gekoppelt ist.

8. Generator nach Anspruch 1, bei dem die Hyperfrequenzleitungen (10, 12) geradlinige Leitungen vom Streifentyp sind, hergestellt aus metallischen Abscheidungen auf zwei Substraten (22, 23) mit unterschiedlichen dielektrischen Konstanten (ε).
